# EUROPEAN PATENT APPLICATION

(11) **EP 2 339 643 A2**
(43) Date of publication of application: **29.06.2011**
(21) Application number: 10196024.3
(22) Date of filing: 20.12.2010
(51) Int. Cl.: H01L 31/0352, H01L 31/072, H01L 31/0296

(54) **Photovoltaic cell**

(30) Priority: 23.12.2009 US 645618
(71) Applicant: General Electric Company, Schenectady, NY 12345 (US)
(72) Inventor: Korevaar, Bastiaan Arie, Niskayuna, NY 12309 (US); Tsakalakos, Loucas, Niskayuna, NY 12309 (US); Ahmad, Faisal Razi, Niskayuna, NY 12309 (US)
(74) Representative: Szary, Anne Catherine

(57) **Abstract**

A photovoltaic (PV) cell (200) is disclosed. The PV cell comprises, a plurality of ultrafine structures (202) electrically coupled to, and embedded within, a polycrystalline photo-active absorber layer (204) comprising a p-type compound semiconductor.

## Description

### BACKGROUND

The invention relates generally to the area of semiconductor photovoltaic (PV) cells. More specifically, the invention relates to the area of PV cells wherein the semiconductor absorber material employed is cadmium telluride (CdTe).

The solar spectrum "sunlight" contains a distribution of intensity as a function of frequency. It can be shown that the conversion efficiency for utilizing sunlight to obtain electricity via semiconductors is optimized for semiconducting band-gaps that range from about 1.4-1.5 electron volt (eV). The semiconducting band-gap of CdTe, is a good match for this requirement. Quite generally, in the interest of brevity of the discussions herein, PV cells including CdTe as the photo-active material may be referred to as "CdTe PV cells."

Commercial feasibility of large-scale CdTe PV installations has been demonstrated, and the cost of electricity obtained from such large-scale CdTe PV installations is approaching grid parity. Commercial feasibility of smaller scale, that is, area confined, installations remains a challenge within the art due to the relatively poor overall efficiency of such smaller scale installations. Despite significant academic and industrial research and development effort, the best efficiencies for CdTe PV cells have been stagnant for close to a decade, at about 16.5%, even as the entitlement-efficiency of CdTe PV cells for the solar energy spectrum is about 23%. These conversion efficiency numbers may be compared to the overall efficiency of typical currently available commercial large-scale CdTe PV installations including such CdTe PV cells, which conversion efficiency is lower at about 10-11%.

Improvement in the overall efficiency of CdTe PV installations will enhance their competitiveness compared to traditional methods of generating electricity such as from natural gas, or coal. It is evident that improvement in overall efficiency will enable CdTe PV technology to successfully penetrate markets where small-scale area confined installations are required, such as markets for domestic PV installations.

A CdTe PV cell design that is more reliable and enables conversion efficiencies in excess of the efficiencies of present generation CdTe PV cells, would therefore be highly desirable.

### BRIEF DESCRIPTION

Embodiments of the invention are directed to a photovoltaic cell.

A photovoltaic (PV) cell comprising, a plurality of ultrafine structures electrically coupled to, and embedded within, a polycrystalline photo-active absorber layer comprising p-type cadmium telluride (CdTe).

A photovoltaic solar cell, comprising, an optical-window-electrode (OWE) layer, a plurality of ultrafine structures comprising an n-type semiconductor electrically coupled to, and embedded within and substantially along a thickness direction of, a polycrystalline photo-active absorber layer comprising p-type cadmium telluride (CdTe), and a electrode layer comprising a p-type semiconductor.

A photovoltaic (PV) cell comprising, a plurality of ultrafine structures electrically coupled to, and embedded within, a polycrystalline photo-active absorber layer comprising a p-type compound semiconductor.

These and other advantages and features will be more readily understood from the following detailed description of preferred embodiments of the invention that is provided in connection with the accompanying drawings.

### DRAWINGS

FIG. 1 is a diagrammatic illustration of a portion of a generic PV cell including a p-type CdTe layer.
FIG. 2 is a diagrammatic illustration of a CdTe PV cell, in accordance with one embodiment of the invention.
FIG. 3 is a diagrammatic illustration of a plurality of metallic ultrafine structures having a conformal coating of a n-type semiconductor, in accordance with one embodiment of the invention.
FIG. 4 is a diagrammatic illustration, substantially of a portion of the PV cell shown in FIG. 2, in accordance with one embodiment of the invention.

### DETAILED DESCRIPTION

In the following description, whenever a particular aspect or feature of an embodiment of the invention is said to comprise or consist of at least one element of a group and combinations thereof, it is understood that the aspect or feature may comprise or consist of any of the elements of the group, either individually or in combination with any of the other elements of that group.

As discussed in detail below, embodiments of the invention are directed to improved photovoltaic (PV) cell designs. Particular embodiments of the invention proposed here provide for a PV cell including a photo-active absorber layer including n-type CdTe, and having an efficiency that is enhanced over the efficiencies of presently available CdTe PV cells (about 16.5%). Embodiments of the CdTe PV cell disclosed herein may display an efficiency that approaches, or even exceeds, about 20%. The photo-active absorber layer disclosed herein is the part of the PV cell where the conversion of electromagnetic energy of incident light, for instance, sunlight, to electrical energy occurs.

However, as discussed in more detail below, quite generally, it is envisaged that the designs and concepts proposed herein will be useful for the development of PV cells including a photo-active absorber layer that includes compound semiconductors other than CdTe. Non-limiting examples of compound semiconductors include gallium arsenide, indium gallium arsenide, indium phosphide, copper indium gallium selenide, copper indium sulphide, Cu(In,Ga,Al,Ag)(S,Se)₂, or copper zinc tin sulphide.

In the discussions herein, the term "ultrafine structures" will be understood to include structures such as nanowires, nanotubes, quantum wires, quantum dots, nanowalls, and combinations thereof of such structures, as also any other structure capable of displaying physical properties similar to one or more physical properties of the aforementioned structures. Quite generally, the term "ultrafine structures" will be understood to include any structure wherein a smallest physical dimension of, or feature of, the structure has a spatial extent "aᵤₛ" of less than about 1 micrometer. It will be appreciated that, for instance, a "mesh," for instance, of nanowires, wherein the mesh extends over a spatial extent in excess of aᵤₛ, but wherein at least a portion of the nanowires have at least one physical dimension that is substantially less than aᵤₛ, is a specific non-limiting example of an ultrafine structure according to the present definition. Further, it will be understood that, for instance, ultrafine structures, wherein a spatial extent, of at least some of the features, such as pores or voids, characterizing the ultrafine structures, is less than about 1 micrometer, fall within the purview of the present invention. In particular embodiments of the invention disclosed herein, the ultrafine structures may be disposed on a substrate, for instance, a thin-film, of the same material from which the ultrafme structures are formed. In more particular embodiments of the invention disclosed herein, the substrate may be formed from a dielectric material, which substrate may also serve as a template for the growth of the ultrafine structures.

Quite generally, in the interest of brevity of the discussions herein, PV cells including CdTe as the photo-active material may be referred to as "CdTe PV cells." The type of doping (p-type or n-type) of the CdTe will be specified, although is non-limiting.

Those of skill in the art would be aware that the effective carrier density of CdTe is a function of the defects and impurities present therein. Also, the photo-active absorber layers employed in CdTe PV cells are substantially polycrystalline, that is, they are composed of a multitude of grains with grain boundaries mediate the grains. Those of skill in the arts of photovoltaics and thin films would appreciate that the grain boundaries are regions of defects. The presence of these defects leads to the creation of additional electronic states within the semiconducting band-gap of CdTe. These additional states, which may be acceptor states, or donor states, can affect the physical properties, for instance, the optical and electrical properties, of the photo-active absorber layer.

As will be discussed in context of embodiments of the instant invention, a control of the active function, that is, the function related to charge carrier transport, of the grain boundaries, can result in enhanced conversion efficiency levels beyond those possible for present generation CdTe PV cell designs.

It will be appreciated, that the feasibility of any proposed scheme for such control of the active function of the grain boundaries, will be augmented, if the materials and processes enabling the scheme, are compatible with extant CdTe PV cell design and fabrication paradigms.

p-type CdTe is currently the most commonly used material in PV cells where the photo-active material is CdTe. Present generation CdTe PV cells utilize p-type CdTe to form an absorber layer. The absorber layer is the part of the PV cell where the conversion of electromagnetic energy of incident light (for instance, sunlight), to electrical energy (that is, to electrical current), occurs. Present generation CdTe PV cells, however, suffer from multiple issues that have hampered the development of high performance CdTe PV cells with efficiencies approaching the entitlement-efficiency of the CdTe PV cells for the solar energy spectrum.

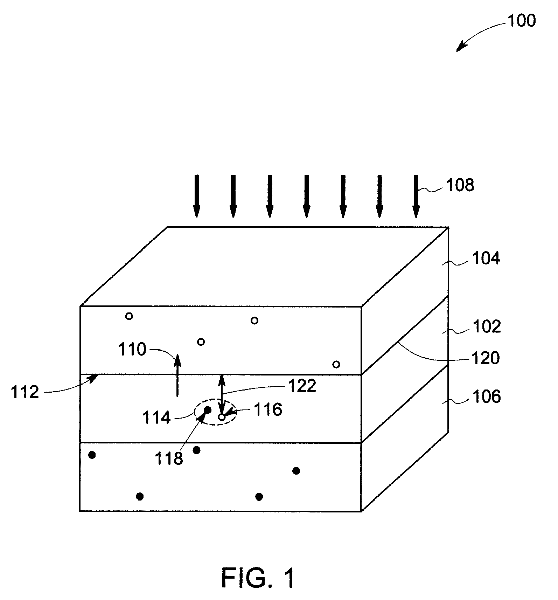

FIG. 1 is a diagrammatic illustration of a portion 100 of a CdTe PV cell design, for the purposes of discussion of some general operational principles of PV cells. The portion 100 shown includes three layers, 102, 104, and 106. The PV cell portion 100 includes a p-type CdTe layer 102 that is disposed mediate to an n-type optical window layer 104 and an electrode layer 106. The interface between the p-type CdTe layer 102 and the n-type optical window layer 104 may properly be considered as a hetero-junction 112. An electric field 110 is generated across the hetero-junction 112 between the p-type CdTe layer 102 and the n-type optical window layer 104, according to principles that would be known to one of skill in the art of photovoltaics. Light energy flux 108, when it is allowed to be incident on the optical window layer 104, continues on to the CdTe layer 102, wherein the light energy is absorbed to generate electron-hole pairs, that is, the light energy is absorbed to generate electricity. An instance of an electron-hole pair is indicated via reference numeral 114, the hole 118 of the electron-hole pair 114 drifts, under the action of the electric field 110, towards the electrode layer 106 for collection. Similarly, the electron 116 of the electron-hole pair 114 drifts, under the action of electric field 110, towards the n-type optical window layer 104 for collection. In effect therefore, the electrode layer 106 serves as the positive electrode to an external electrical load (not shown in FIG. 1) that is connected to the PV cell (of which portion 100 is a part), while the n-type optical window layer 104 serves also as a negative electrode to the external electrical load that is connected to the PV cell.

Joule dissipation is among the factors limiting the efficiency of PV cells that include CdTe absorber layers, such as the CdTe PV cell 100. Furthermore, the optical window layer, commonly used in present generation CdTe PV cells is also a seat of loss of efficiency since it absorbs a portion of incident light energy flux before it reaches the CdTe absorber layer, which absorbed portion of light energy flux is therefore unavailable, for generation of photo-generated charge carriers, that is, for the generation of electrical current. For instance, one of the commonly used materials to form optical window layers in present generation CdTe PV cells that include p-type CdTe absorber layers, is n-type CdS. It is known that typical n-type CdS optical window layers (having typical thickness of about 50 - 200 nanometers) result in a loss of about 2-5 milli Amperes per square centimeter (mA/cm²) of electrical current due to absorption of incident light flux. If schemes can be found, to mitigate the above discussed dissipation modes within the CdTe absorber layer, as well as to address the loss of incident light energy flux in the optical window layer, then it is likely that CdTe PV cells that are designed according to such schemes would possess efficiencies enhanced over the efficiencies of present generation CdTe PV cells.

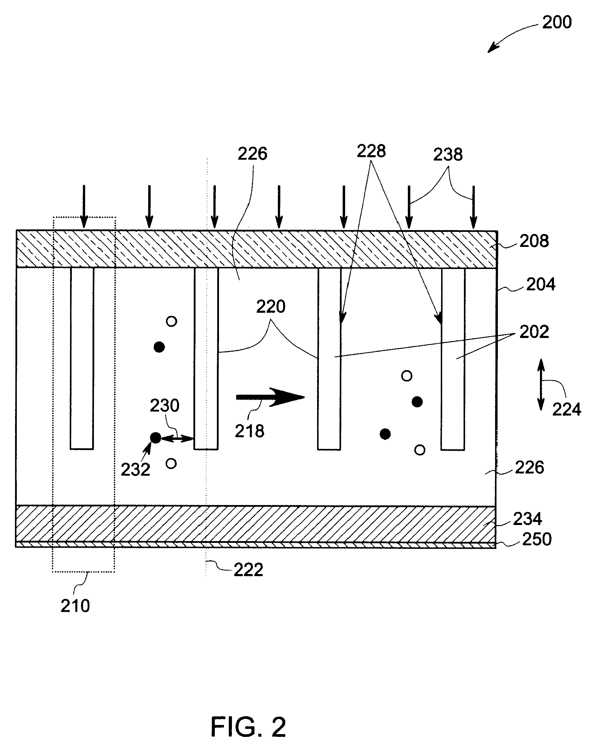

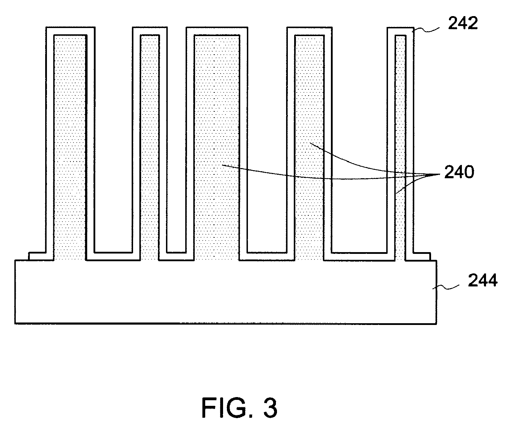

As discussed in detail below in relation to FIG. 2 and FIG. 3, embodiments of the invention disclosed herein provide approaches that have potential to enable development of improved CdTe PV cell designs that include p-type CdTe absorber layers. PV cell designs according to embodiments of the present invention provide schemes to mitigate the joule dissipation within the CdTe absorber layer, as well as to address the loss of incident light energy flux in the optical window layer. Furthermore, the materials and processes enabling the schemes proposed herein, are compatible with extant CdTe PV cell design and fabrication paradigms. Embodiments of the present invention therefore may economically enable the development of PV cells including a photo-active absorber layer including p-type CdTe, with efficiencies approaching or exceeding the entitlement-efficiency (- 23%) of CdTe PV cells for the solar energy spectrum. Particular embodiments of the invention disclosed herein have the potential to enable development of CdTe PV cells with efficiencies in excess of about 17%.

FIG. 2 is a diagrammatic illustration of a PV cell 200 in accordance with one embodiment of the invention, shown in side cross-sectional view. The PV cell 200 includes a plurality of ultrafine structures 202 comprising an n-type material, which plurality of ultrafine structures 202 are coupled electrically and mechanically to a subtrate 208. Furthermore, the plurality of ultrafine structures 202 are embedded within, and in electrical communication with, the polycrystalline photo-active absorber layer 204, which photo-active absorber layer 204 comprises p-type CdTe. Furthermore, the photo-active absorber layer 204, is in electrical communication with an electrode layer 234, which electrode layer 234 comprises a p-type semiconductor. Furthermore, at least a portion of the plurality of ultrafine structures 202 are aligned so that their longitudinal axes 222 independently lie substantially along a thickness direction 224 of the photo-active absorber layer 204. The subtrate 208 may be any metallic, or semiconducting template that is suitable for the growth of ultrafine structures, and also possesses appropriate electrical characteristics to serve as an electrode, as also appropriate optical characteristics to serve as an optical window layer. In other words therefore, the substrate 208 should possess appropriate electro-optical characteristics to serve also as an optical-window-electrode layer (OWE) layer. In a non-limiting embodiment of the PV cell 200, the substrate 208 may be formed as a layer of a transparent conducting oxide on glass. Non-limiting examples of transparent conducting oxides include, indium tin oxide (ITO), indium zinc oxide (IZO), aluminum zinc oxide (AZO), amorphous zinc oxide (aZO), cadmium stannate (Cd₂SnO₄) zinc oxide (ZnO), tin oxide (SnO₂), indium oxide (In₂O₃), cadmium tin oxide, fluorinated tin oxide, and combinations thereof. In other non-limiting embodiments of the invention, the substrate 208 includes n-type cadmium sulphide (CdS) or any other appropriate n-type material having properties that allow the substrate 208 to serve as an OWE layer.

Quite generally, the subtrate 208 coupled to the plurality of ultrafine structures 202 serves as the negative electrode for an electrical load (not shown) connected to the PV cell 200, while the electrode layer 234 coupled to the photo-active absorber layer 204 serves as a positive electrode for the electrical load (not shown) connected to the PV cell 200.

The plurality of ultrafine structures 202 include at least one n-type material, wherein the n-type material includes semiconductors, or transparent conducting oxides. In one embodiment of the invention, a carrier density within the n-type material lies within a range from about 10¹⁶ per cubic centimeter (/cm³) to about 10¹⁸ /cm³. In one embodiment of the invention, a carrier density within the n-type material can be up to about 10²¹ /cm³. In one embodiment of the invention, the plurality ultrafine structures comprise an n-type material coated with an n-type semiconductor. Non-limiting examples of the n-type semiconductor include n-type cadmium sulphide. In one embodiment of the invention, the n-type semiconductor has a carrier density of that lies within a range from about 10¹⁵ /cm³ to about 10¹⁹ /cm³. In one embodiment of the invention, the n-type semiconductor has a carrier density that lies within a range from about 10¹⁵ /cm³ to about 2 x 10²⁰.

It is clarified that, even though in FIG. 2, the plurality of ultrafme structures 202 disposed substantially throughout the photo-active absorber layer 204, PV cell embodiments of wherein the plurality of ultrafine structures 204 are disposed only within certain regions of the photo-active absorber layer 204, fall within the purview of the present invention. Furthermore, PV cells wherein the plurality of ultrafine structures 202 are disposed non-homogenously within the photo-active layer 204 fall within the purview of the present invention.

Particular non-limiting embodiments of the invention include a plurality of ultrafine structures that include a plurality of metallic ultrafme structures conformally coated with an n-type semiconductor. For instance, FIG. 3 is a diagrammatic illustration of a plurality of metallic ultrafine structures 240 of type 202 having a conformal coating 242, wherein the conformal coating 242 comprises an n-type semiconductor. Quite generally therefore, PV cell embodiments including a plurality of ultrafine structures including a plurality of metallic ultrafine structures wherein at least a portion of the plurality of metallic ultrafine structures have a conformal coating comprising a n-type semiconductor, fall within the purview of the present invention.

An electric field 218 is generated across a p-n junction 220 between the photo-active absorber layer 204 comprising p-type CdTe and the plurality of ultrafine structures 202 comprising a n-type semiconductor, according to principles that would be known to one of skill in the art of photovoltaics. In the embodiment presently under discussion, the electric field 218 would be directed substantially "inwards" from bulk portions 226 of the p-type CdTe layer 204 towards the individual ultrafine structures of the plurality of ultrafme structures 202.

On the basis of the descriptions provided, it should be evident to one of skill in the art that the p-n junction 220, is "distributed," along the interface regions 228 between the plurality of ultrafme structures 202, and the bulk portions 226 of the photo-active absorber layer 204. Evidently, the interface regions 228 are "spread-out" across the bulk of the photo-active absorber layer 204. PV cell designs according to embodiments of the present invention possess several enhancements over present generation PV cell designs, as are now discussed.

As will be discussed in more detail in relation to FIG. 3, at least a portion of a light energy flux 238 incident on the substrate 208 continues on to the photo-active absorber layer 204, wherein it causes the generation of electron-hole pairs. For example, reference numeral 232 indicates an example of such a photo-generated electron. Due to the distributed nature of the p-n junction 220, the "average" distance 230 between a photo-generated charge carrier, for instance, the photo-generated electron 232, and the p-n junction 220, decreases (over for instance, the average distance 122 between the p-n junction interface 120 (FIG. 1) and photo-generated charge carriers, for instance the electron 116 as depicted in FIG. 1). Evidently therefore, the distance that a photo-generated charge carrier needs to travel before being collected at an electrode would also diminish. Consequently, levels of joule dissipation in PV cells according to the presently disclosed designs (for instance, PV cell 200), are likely to be diminished, over PV cells according to present generation designs. In turn, a diminution in joule dissipation is likely to result in an increase in the reliability of PV cells fabricated according to embodiments of the present invention, over present generation designs. In some embodiments of the invention, the thickness of the photo-active absorber layer 204 can be up to about 10 micrometers. In one embodiment of the invention, the thickness of the photo-active absorber layer 204 can be up to about 5 micrometer. In another embodiment of the invention, the thickness of the photo-active absorber layer 204 can be up to about 3 micrometer.

It is also envisaged that, since the p-n junction interfaces have effectively been "transferred" to within the bulk of the photo-active absorber layer 204 (as opposed to the p-n junction 112 which lies along the edge 120 of the photo-active absorber layer 102 of CdTe PV cell 100), embodiments of the present invention, may be exempt from the requirement of a n-type CdS optical window layer (of type 104) in order to perform a photovoltaic function. In such embodiments of the invention therefore, the substrate 208 may itself be formed from a material (such as a transparent conducting oxide) having appropriate electrical and optical characteristics to serve as an OWE layer. This lifting of the requirement of the CdS optical window layer would likely contribute to an increase in the efficiency of the CdTe PV cell as per the discussions herein. It is clarified, however, that CdTe PV cell designs comprising an OWE layer comprising n-type CdS fall within the purview of the present invention.

The open circuit voltage "V_{OC}" and the short circuit current density "J_{SC}" are among the standard figures of merit on the basis of which performance of PV cells may be evaluated. Embodiments of the invention include PV cells (for instance, of type 200) that are capable of generating an open circuit voltage "V_{OC}" of up to about 0.85 Volt. Alternate embodiments of the invention include PV cells (for instance, of type 200) that are capable of generating a short circuit current density "J_{SC}" of up to about 0.025 Ampere/cm². Due to such range of achievable values of V_{OC} and J_{SC}, it is envisaged that PV cells according to embodiments of the present invention, will be capable of achieving a J_{SC} of up to about 0.028 A/cm², leading to efficiencies (for conversion of light energy to electrical energy) of greater than about 16% and up to about 20%.

In one embodiment of the invention, the plurality of ultrafine structures 202 include cadmium telluride (CdTe), cadmium sulphide (CdS), zinc telluride (ZnTe), zinc selenide (ZnSe), cadmium selenide (CdSe), zinc sulphide (ZnS), indium selenide (In₂Se₃), indium sulphide (In₂S₃), or zinc oxyhydrate. In one embodiment of the invention, at least a portion of the plurality of ultrafine structures 202 comprise a structure comprising at least one nanowire, or at least one nanotube, or at least one quantum wire, or at least one quantum dot, or at least one nanowall. In particular, individual ultrafine structures of the plurality of ultrafine structures 202 may be formed as a "pillar," or "string" of quantum dots. In one embodiment of the invention, at least one physical dimension of at least a portion of the plurality of ultrafine structures is less than about 1 micrometer. In more particular embodiments of the invention, at least one physical dimension of at least a portion of the plurality of ultrafine structures is less than about 500 nanometers. In more particular embodiments of the invention, at least one physical dimension of at least a portion of the plurality of ultrafine structures is less than about 200 nanometers. In more particular embodiments of the invention, at least one physical dimension of at least a portion of the plurality of ultrafine structures is less than about 100 nanometers.

As discussed, in one embodiment of the invention, the plurality of ultrafine structures include an n-type semiconductor material. In one embodiment of the invention, the plurality of ultrafine structures comprise a material having a semiconducting band-gap substantially greater than the semiconducting band-gap of the p-type CdTe of the photo-active absorber layer 204. In one embodiment of the invention, the plurality of ultrafme structures comprise a material having a semiconducting band-gap substantially equal to the semiconducting band-gap of the p-type CdTe from which is comprised the photo-active absorber layer 204.

In one embodiment of the invention, a carrier density within the photo-active absorber layer 204 lies within a range from about 10¹⁴/cm³ to about 10¹⁶ /cm³. In one embodiment of the invention, a carrier density within the plurality of ultrafine structures 202 lies within a range from about 10¹⁵ /cm³ to about 10¹⁹ /cm³.

In one embodiment of the invention, the PV cell 200 further includes a contact electrode layer 250 comprising a p-type material in electrical contact with the photo-active absorber photo-active absorber layer 204 comprising p-type CdTe. In one embodiment of the invention, the contact electrode layer 250 comprises a transparent conducting oxide. In particular embodiments of the invention, the contact electrode layer 250 is configured to function as an optical-window-electrode (OWE) layer. In one embodiment of the invention, the contact electrode layer 250 has higher carrier density than the photo-active absorber layer 204. In one embodiment of the invention, the contact electrode layer 250 has a carrier density greater than about 5 x 10¹⁷ /cm³. In one embodiment of the invention, the contact electrode layer 250 comprises a material comprising BaCuXF, wherein 'X' comprises sulphur, selenium, or tellurium. In one embodiment of the invention, the contact electrode layer 250 comprises a material comprising LaCuOX, wherein 'X' comprises sulphur, selenium, or tellurium. In one embodiment of the invention the contact electrode layer 250 comprises a material comprising XCuO(S_{1-y},Se_{y}), wherein 'X' comprises praseodymium, neodymium, or a lanthanide, and 'y' can assume values between zero and one. In one embodiment of the invention the contact electrode layer 250 comprises Sr₂Cu₂ZnO₂S₂ or Sr₂CuGaO₃S.

Based on the discussions herein, those of skill in the art may now appreciate that, quite generally, embodiments of the invention include, a PV cell (for instance, of type 200) including, a plurality of ultrafme structures (for instance, of type 202) electrically coupled to, and embedded within, a polycrystalline photo-active absorber layer (for instance, of type 204) comprising p-type CdTe.

FIG. 3 is a diagrammatic illustration 300 of a portion 210 of the PV cell 200 shown in FIG. 2. Reference numerals 302, and 304 indicate respectively portions of the photo-active absorber layer 204, and of the subtrate 208, while reference numeral 306 indicates a single ultrafine structure of the plurality of ultrafine structures 202. Reference numeral 334 indicates a portion of the contact electrode layer 250. A portion of the electric field 218 is indicated via reference numeral 316, which electric field portion 316, according to principles that would be known to one of skill in the art of photovoltaics, points inwards from a bulk portion 302 of the photo-active absorber layer 304 (204) towards the ultrafine structure 306 of the plurality of ultrafine structures 202. In other words, electric field portion 316 points substantially "outwards" from the single ultrafine structure 306 and towards a bulk portion 302 of the photo-active absorber layer 204. At least a portion of light energy flux 308 incident on the subtrate 304 (208) continues on to the photo-active absorber layer 302 (204) where it causes the generation of electron-hole pairs. It is pointed out that, bifacial PV cell embodiments, wherein a light energy flux 336 may be incident on the contact electrode layer 334 (250), and which light energy flux 336 will also cause a generation of electron-hole pairs, fall within the purview of the present invention. An instance of such a photo-generated electron-hole pair is indicated via reference numeral 310, the electron 312 of the electron-hole pair 310 drifts, under the action of the electric field 316, towards the single ultrafine structure 306, for collection. Similarly, the hole 314 of the electron-hole pair 310 drifts, under the action of electric field 316, towards the p-type semiconductor layer 326 (234) for collection. The direction of drift of the electron 312 and the hole 314 are indicated via reference numerals 318 and 320 respectively. Quite generally, the general direction of drift of electrons towards the ultrafine structure 306 (202), and of the holes towards the electrode layer 326 (234) are indicated by reference numerals 322 and 324 respectively. In effect therefore, within embodiments of the invention proposed herein, the subtrate 304 (208) coupled to the ultrafme structure 306 (202) comprising an n-type material, serves as the negative electrode of the PV cell 200, while the electrode layer 326 (234) comprising a p-type semiconductor and coupled to the photo-active absorber layer 302 (204) comprising p-type CdTe serves as the positive electrode of the PV cell 200.

Bifacial PV cell embodiments, wherein light energy flux incident upon the substrate 304 (208), as well as upon the p-type contact electrode layer 334 (250), is used for photo-current generation, fall within the purview of the present invention. Within such bifacial embodiments, the substrate 304 (208) as well as the contact electrode layer 334 (250) serve as OWE layers. In such bifacial embodiments, a light energy flux 308, and light energy flux 340, may be allowed to be incident, on the substrate 304 (208), and on the contact electrode layer 334 (250), to result in generation of electron-hole pairs. The specific attributes required of the substrate 304 (208), and of the contact electrode layer 334 (250), to realize such "bifacial" embodiments of the PV cell are discussed herein. However, it is pointed out that, PV cells wherein photo-current generation occurs substantially only due to light energy flux incident upon one or the other, of the substrate 304 (208), or the contact electrode layer 334 (250), fall within the purview of the present invention.

As discussed, a substantial portion of the photo-current generation occurs within the photo-active absorber layer 204, and within which photo-active absorber layer 204 are embedded the plurality of ultrafine structures 202. It is noted that, within embodiments of the invention disclosed herein, the plurality of ultrafine structures 202 serve to collect the photo-generated holes generated substantially within the photo-active layer 204.

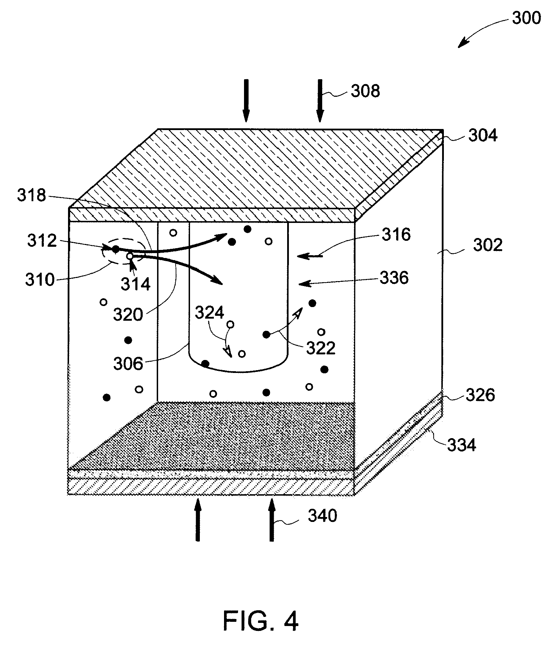

As discussed at least in context of the embodiments of the invention depicted in FIGS. 2, 3, and 4, the plurality of ultrafine structures 202 are embedded with the photo-active absorber layer 204. It is noted that the photo-current generation within embodiments of the present invention takes place substantially within the photo-active absorber layer, while the plurality of ultrafine structures 202 serve to extract at least a portion of the photo-current. (However, the inventors recognize that photo-current generation likely occurs also within the plurality of ultrafme structures 202. However, it is likely that a substantially significant portion of the photo-current generation occurs within the photo-active absorber layer 204.) It is envisaged that the typical spacing between individual ultrafine structures of the plurality of ultrafine structures 202, may advantageously be at least of the order of twice the depletion length scale of the p-n junction 220. Such spacing would likely result in a diminution in overlap of electric fields within the depletion regions surrounding and corresponding to the individual ultrafine structures.

It view of the discussions herein, it may be appreciated that, embodiments of the invention include a photovoltaic solar cell (for instance, of type 200), including an OWE layer (for instance, a subtrate of type 208), a plurality of ultrafme structures (for instance, ultrafine structures of type 202) electrically coupled to, and embedded within and substantially along a thickness direction (for instance, of type 224) of, a polycrystalline photo-active absorber layer (for instance, of type 204) comprising p-type CdTe, and a electrode layer (for instance, of type 234) comprising p-type semiconductor.

In view of the discussions herein, it may now be appreciated that, quite generally, embodiments of the invention include a PV cell (similar in structure to the PV cell 200) including a plurality of ultrafine structures (for instance, of type 202) embedded within a photo-active absorber layer (similar in structure to the photo-active absorber layer 204) comprising a p-type compound semiconductor. Non-limiting examples of compound semiconductors include gallium arsenide, indium gallium arsenide, copper indium gallium selenide, Cu(In,Ga,Al,Ag)(S,Se)₂, copper zinc tin sulphide, and combinations thereof.

While the invention has been described in detail in connection with only a limited number of embodiments, it should be readily understood that the invention is not limited to such disclosed embodiments. Rather, the invention can be modified to incorporate any number of variations, alterations, substitutions or equivalent arrangements not heretofore described, but which are commensurate with the spirit and scope of the invention. Additionally, while various embodiments of the invention have been described, it is to be understood that aspects of the invention may include only some of the described embodiments. Accordingly, the invention is not to be seen as limited by the foregoing description, but is only limited by the scope of the appended claims.

For completeness, various aspects of the invention are now set out in the following numbered clauses:
1. A photovoltaic (PV) cell comprising:
   a plurality of ultrafine structures electrically coupled to, and embedded within, a polycrystalline photo-active absorber layer comprising p-type cadmium telluride (CdTe).
2. The PV cell of clause 1, further comprising an optical-window-electrode (OWE) layer.
3. The PV cell of clause 2, wherein the OWE layer comprises cadmium sulphide.
4. The PV cell of clause 1, wherein the plurality of ultrafine structures comprise a plurality of metallic ultrafine structures wherein at least a portion of the plurality of metallic ultrafine structures have a conformal coating comprising a n-type semiconductor.
5. The PV cell of clause 1, wherein the plurality of ultrafme structures comprise an n-type material.
6. The PV cell of clause 5, wherein the n-type material comprises a n-type transparent conducting oxide.
7. The PV cell of clause 6, wherein the transparent conducting oxide comprises at least one of indium tin oxide, indium zinc oxide, aluminum zinc oxide, amorphous zinc oxide, cadmium stannate, zinc oxide, tin oxide, indium oxide, cadmium tin oxide, or fluorinated tin oxide.
8. The PV cell of clause 5, wherein a carrier density within the n-type material lies within a range from about 10¹⁶ /cm³ to about 10¹⁸ /cm³.
9. The PV cell of clause 1, wherein the plurality of ultrafine structures comprise a n-type semiconductor.
10. The PV cell of clause 9, wherein the n-type semiconductor comprises cadmium telluride, cadmium sulphide, zinc telluride, zinc selenide, cadmium selenide, zinc sulphide, indium selenide, indium sulphide, or zinc oxyhydrate.
11. The PV cell of clause 9, wherein a semiconducting band-gap of the n-type semiconductor is greater than a semiconducting band-gap of the p-type CdTe.
12. The PV cell of clause 9, wherein a semiconducting band-gap of the n-type semiconductor is substantially equal to a semiconducting band-gap of the p-type CdTe.
10. The PV cell of clause 1, wherein the photo-active absorber layer has a thickness of up to about 10 micrometers.
11. The PV cell of clause 1, wherein at least a portion of the plurality of ultrafine structures are aligned so that their longitudinal axes independently lie substantially along a thickness direction of the photo-active absorber layer.
12. The PV cell of clause 1, further comprising a contact electrode layer in electrical contact with the photo-active absorber layer.
13. The PV cell of clause 15, wherein the contact electrode layer comprises a transparent conducting oxide.
14. The PV cell of clause 15, wherein the contact electrode layer comprises a p-type material.
15. The PV cell of clause 17, wherein a carrier density within the p-type material is substantially higher than a carrier density within the p-type CdTe.
16. The PV cell of clause 17, wherein the p-type material has a carrier density greater than about 5 x 10¹⁷ /cm³.
17. The PV cell of clause 17, wherein the p-type material comprises BaCuXF, wherein 'X' comprises sulphur, selenium, or tellurium.
18. The PV cell of clause 17, wherein the p-type material comprises LaCuOX, wherein 'X' comprises sulphur, selenium, or tellurium.
19. The PV cell of clause 17, wherein the p-type material comprises XCuO( S_{1-y}, Se_{y}), wherein 'X' comprises praseodymium, neodymium, or a lanthanide, and wherein 'y' can assume values between zero and one.
20. The PV cell of clause 17, wherein the p-type material comprises Sr₂Cu₂ZnO₂S₂, or Sr₂CuGaO₃S.
21. The PV cell of clause 15, wherein the contact electrode layer is configured to function as an optical-window-electrode (OWE) layer.
22. The PV cell of clause 24, wherein the PV cell is bifacial.
23. The PV cell of clause 1, wherein a carrier density within the p-type CdTe lies within a range from about 10¹⁴ /cm³ to about 10¹⁶ /cm³.
24. The PV cell of clause 1, wherein at least one physical dimension of at least a portion of the plurality of ultrafine structures is less than about 1 micrometer.
25. The PV cell of clause 1, wherein a spatial extent of a feature characterizing the plurality of ultrafine structures is less than about 1 micrometer.
25. The PV cell of clause 1, wherein at least a portion of the plurality of ultrafine structures comprise a structure comprising at least one nanowire, or at least one nanotube, or at least one quantum wire, or at least one quantum dot, or at least one nanowall, or combinations thereof.
26. A photovoltaic solar cell, comprising:
   an optical-window-electrode (OWE) layer;
   a plurality of ultrafine structures comprising an n-type semiconductor electrically coupled to, and embedded within and substantially along a thickness direction of, a polycrystalline photo-active absorber layer comprising p-type cadmium telluride (CdTe); and
   a electrode layer comprising a p-type semiconductor.
27. A photovoltaic (PV) cell comprising:
   a plurality of ultrafine structures electrically coupled to, and embedded within, a polycrystalline photo-active absorber layer comprising a p-type compound semiconductor.
28. The PV cell of clause 31, wherein the compound semiconductor comprises gallium arsenide, indium gallium arsenide, indium phosphide, copper indium gallium selenide, copper indium sulphide, Cu(In,Ga,Al,Ag)(S,Se)2, or copper zinc tin sulphide.

## Claims

**1.** A photovoltaic (PV) cell (200) comprising:
a plurality of ultrafine structures (202) electrically coupled to, and embedded within, a polycrystalline photo-active absorber layer (204) comprising p-type cadmium telluride (CdTe).

**2.** The PV cell of claim 1, further comprising an optical-window-electrode (OWE) layer (208).

**3.** The PV cell of claim 2, wherein the OWE layer comprises cadmium sulphide.

**4.** The PV cell of any preceding claim, wherein the plurality of ultrafine structures (202) comprise a plurality of metallic ultrafine structures (240) wherein at least a portion of the plurality of metallic ultrafine structures have a conformal coating (242) comprising a n-type semiconductor.

**5.** The PV cell of claim 1 or claim 2, wherein the plurality of ultrafine structures (202) comprise an n-type material.

**6.** The PV cell of claim 5, wherein the n-type material comprises a n-type transparent conducting oxide.

**7.** The PV cell of claim 6, wherein the transparent conducting oxide comprises at least one of indium tin oxide, indium zinc oxide, aluminum zinc oxide, amorphous zinc oxide, cadmium stannate, zinc oxide, tin oxide, indium oxide, cadmium tin oxide, or fluorinated tin oxide.

**8.** The PV cell of claim 5, wherein a carrier density within the n-type material lies within a range from about 10¹⁶ /cm³ to about 10¹⁸ /cm³.

**9.** The PV cell of claim 1, wherein the plurality of ultrafine structures comprise a n-type semiconductor.

**10.** The PV cell of any preceding claim, wherein the photo-active absorber layer (204) has a thickness of up to about 10 micrometers.

**12.** The PV cell of any preceding claim, wherein at least one physical dimension of at least a portion of the plurality of ultrafine structures (202) is less than about 1 micrometer.

**13.** The PV cell of any preceding claim, wherein at least a portion of the plurality of ultrafine structures (202) comprise a structure comprising at least one nanowire, or at least one nanotube, or at least one quantum wire, or at least one quantum dot, or at least one nanowall, or combinations thereof.

**14.** A photovoltaic solar cell (200), comprising:
an optical-window-electrode (OWE) layer (208);
a plurality of ultrafine structures (202) comprising an n-type semiconductor electrically coupled to, and embedded within and substantially along a thickness direction (224) of, a polycrystalline photo-active absorber layer (204) comprising p-type cadmium telluride (CdTe); and
a electrode layer comprising a p-type semiconductor.

**15.** A photovoltaic (PV) cell (200) comprising:
a plurality of ultrafine structures (202) electrically coupled to, and embedded within, a polycrystalline photo-active absorber layer (204) comprising a p-type compound semiconductor.
